# EUROPÄISCHE PATENTSCHRIFT

(11) **EP 4 001 857 B1**
(45) Veröffentlichungstag und Bekanntmachung des Hinweises auf die Patenterteilung: **12.04.2023**
(21) Anmeldenummer: 21208661.5
(22) Anmeldetag: 17.11.2021
(51) Int. Cl.: G01F 1/58, G01F 1/684, G01F 1/36

(54) **DURCHFLUSSMESSGERÄT, SENSOREINHEIT UND VERFAHREN ZUR HERSTELLUNG EINES DURCHFLUSSMESSGERÄTS**
FLOW METER, SENSOR UNIT AND METHOD FOR MANUFACTURING A FLOW METER
DÉBITMÈTRE, UNITÉ DE CAPTEUR ET PROCÉDÉ DE FABRICATION D'UN DÉBITMÈTRE

(30) Priorität: 19.11.2020 DE 102020130596
(43) Veröffentlichungstag der Anmeldung: 25.05.2022
(73) Patentinhaber: Krohne AG, 4019 Basel (CH)
(72) Erfinder: Elenbaas, Jacco, 4794RP Heijningen (NL); Braanker, Gijs, 3314BA Dordrecht (NL)
(74) Vertreter: Gesthuysen Patentanwälte

(56) Entgegenhaltungen:
- WO-A1-2020/187370
- CN-U- 214 793 324
- DE-A1-102007 005 670
- US-A1- 2010 180 692
- US-A1- 2010 313 675

## Beschreibung

Die Erfindung geht aus von einem Durchflussmessgerät mit wenigstens einem Messrohr, mit einer Messanordnung zur Messung des Durchflusses eines durch das Messrohr strömenden Mediums, mit wenigstens einer Aufnahmeeinheit für eine Sensoreinheit und mit einer Sensoreinheit, wobei die Aufnahmeeinheit an dem Messrohr angeordnet ist.

Darüber hinaus betrifft die Erfindung eine Sensoreinheit zum Einbau in ein erfindungsgemäßes Durchflussmessgerät mit wenigstens einem Sensor, mit wenigstens einer biegbaren Leiterplatte und mit wenigstens einem Träger, sowie ein Verfahren zur Herstellung eines erfindungsgemäßen Durchflussmessgeräts.

In einigen Anwendungsfällen ist es vorteilhaft, wenn ein Durchflussmessgerät neben der eigentlichen Messeinheit zur Bestimmung des Durchflusses wenigstens eine weitere Sensoreinheit zur Messung von wenigstens einem weiteren Parameter aufweist. In diesen Fällen ist die wenigstens eine weitere Sensoreinheit derart an oder in dem Messrohr anzuordnen bzw. zu platzieren, dass der zusätzliche Sensor einerseits den zu messenden Parameter zuverlässig messen kann und andererseits einfach ein- und auch wieder auszubauen ist.

Aus der Druckschrift DE 10 2011 119 841 A1 ist ein Messgerät mit einer Elektronikeinheit bekannt, wobei die Elektronikeinheit eine flexible Leiterplatte aufweist, auf die mindestens zwei starre Kontaktpins derart gelötet sind, dass ein Ende der Kontaktpins über die flexible Leiterplatte übersteht und wobei die flexible Leiterplatte durch Faltung und/oder Biegung in einen dreidimensionalen Körper verformt ist, wobei der Körper mittels eines faltbaren Trägers in seiner dreidimensionalen Form gehalten wird. Zusätzlich kann auch ein Sensor auf der flexiblen Leiterplatte gelötet sein, wobei die Leiterplatte so gebogen wird, dass der Sensor innerhalb des Messgeräts in der gewünschten Position angeordnet ist. Patentdokument US 2010/313675 A1 offenbart ein Verfahren zur Herstellung eines magnetischen Durchflussmessers, bei dem eine flexible Leiterplatte an einer Elektrode des magnetischen Durchflussmessers befestigt wird, die flexible Leiterplatte in eine Dichtung eingesetzt wird, die Dichtung mit der darin eingesetzten flexiblen Leiterplatte auf einen Mittelstift geschoben wird, die Dichtung mit der darin eingesetzten flexiblen Leiterplatte in eine Registerschale geschoben wird und entweder der Mittelstift oder die Registerschale verformt wird, um die Dichtung zusammenzudrücken, um die flexible Leiterplatte mit einer nahezu hermetischen Dichtung abzudichten.

Der Erfindung liegt ausgehend von diesem Stand der Technik die Aufgabe zugrunde, ein Durchflussmessgerät mit einer zusätzlichen Sensoreinheit anzugeben, die besonders einfach angeordnet und ausgetauscht werden kann.

Zudem liegt der Erfindung die Aufgabe zugrunde, eine Sensoreinheit, die besonders leicht in einem erfindungsgemäßen Durchflussmessgerät angeordnet und ausgetauscht werden kann, sowie ein Verfahren zur Herstellung eines Durchflussmessgeräts anzugeben.

Gemäß einer ersten Lehre der vorliegenden Erfindung wird die zuvor genannte Aufgabe durch ein eingangs genanntes Durchflussmessgerät dadurch gelöst, dass die Sensoreinheit wenigstens einen Sensor, wenigstens eine biegbare Leiterplatte und wenigstens einen Träger umfasst,
wobei der wenigstens eine Sensor auf der wenigstens einen biegbare Leiterplatte angeordnet ist und
dass die Sensoreinheit in die Aufnahmeeinheit eingesteckt ist,
wobei die wenigstens eine biegbare Leiterplatte zumindest teilweise derart um den Träger gewickelt oder gefaltet ist, dass der Sensor im eingesteckten Zustand innerhalb des Messrohrs angeordnet ist.

Erfindungsgemäß wurde erkannt, dass die Anbindung einer biegbaren Leiterplatte an einen Träger insofern vorteilhaft ist, als dass die Leiterplatte zumindest teilweise der Form des Trägers angepasst werden kann. Die Montage der Sensoreinheit kann damit in vorteilhafter Weise durch die Montage des Trägers erfolgen, wobei der Träger lediglich in die Aufnahmeeinheit eingesteckt wird. Gleichzeitig ist dadurch der auf der biegbaren Leiterplatte angeordnete Sensor in dem Messrohr zur Messung des wenigstens einen zusätzlichen Parameters platziert.

Dadurch, dass die biegbare Leiterplatte lediglich um den Träger gewickelt bzw. gefaltet ist, kann auf ein aufwendiges Einbauen und fixieren der Leiterplatte bzw. des zusätzlichen Sensors verzichtet werden.

Wenn es heißt, dass die Sensoreinheit bzw. der Sensor austauschbar in dem Durchflussmessgerät angeordnet ist, so ist damit gemeint, dass weder die Sensoreinheit noch der Sensor in dem Durchflussmessgerät stoffschlüssig angebunden, insbesondere verklebt sind. Der Sensor und/oder die Sensoreinheit sind also nur über form- und/oder kraftschlüssige Verbindungen in dem Durchflussmessgerät angeordnet.

Damit weist die erfindungsgemäße Anordnung den Vorteil auf, dass sie besonders leicht zu montieren ist und darüber hinaus der Sensor leicht austauschbar ist.

Gemäß einer ersten Ausgestaltung ist die Aufnahmeeinheit becherförmig ausgebildet und der Träger der Sensoreinheit ist zumindest teilweise stopfenförmig ausgebildet, sodass der Träger als Stopfen die becherförmige Aufnahmeeinheit verschließt.

Besonders bevorzugt wird die stopfenförmige Sensoreinheit kraftschlüssig in der becherförmigen Aufnahmeeinheit gehalten, sodass die Sensoreinheit einerseits auch bei Vibrationen fixiert angeordnet ist und andererseits nicht herausrutschen kann.

Besonders bevorzugt ist der wenigstens eine Sensor ein Temperatursensor und/oder ein Drucksensor und/oder ein Leitfähigkeitssensor.

Beispielsweise kann durch Anordnung eines Leitfähigkeitssensors in dem Messrohr im Betrieb festgestellt werden, ob das Messrohr vollständig oder nur teilweise mit dem zu messenden Medium gefüllt ist.

Die biegbare Leiterplatte ist beispielsweise als flexible Leiterplatte, insbesondere als Flexfolie, oder als starrflexe Leiterplatte oder als semiflexe Leiterplatte ausgebildet. Eine flexible Leiterplatte ist dabei vollständig, d.h. an jeder Stelle biegbar. Eine solche Ausgestaltung ist insofern vorteilhaft, als dass die flexible Leiterplatte besonders flexibel um den Träger gewickelt bzw. gefaltet werden kann. Zudem kann die biegbare Leiterplatte auch als starrflexe Leiterplatte oder als semiflexe Leiterplatte ausgebildet sein. In diesem Fall weist die biegbare Leiterplatte starre Bereiche auf, die durch flexible Bereiche miteinander verbunden sind. Gemäß dieser Ausgestaltung ist die Leiterplatte über die biegbaren Bereiche um den Träger gewickelt bzw. gefaltet.

Gemäß einer weiter bevorzugten Ausgestaltung umschließt die biegbare Leiterplatte den Träger zumindest teilweise in Längsrichtung und/oder zumindest teilweise quer zur Längsrichtung. Gemäß dieser Ausgestaltung weist der Träger eine Längsachse auf. Insbesondere wenn die biegbare Leiterplatte den Träger sowohl zumindest teilweise in Längsrichtung als auch zumindest teilweise quer zur Längsrichtung umschließt, ist die Leiterplatte stabil um den Träger angeordnet.

Besonders bevorzugt ist der Träger aus Polyamid. Gemäß einer weiteren Ausgestaltung weist der Träger zusätzlich zumindest teilweise eine Schicht umfassend ein Haftmittel und/oder umfassend Elektrolytkupfer auf. Vorzugsweise ist eine Mehrzahl zusätzlicher Schichten vorhanden, die insbesondere ein Haftmittel und/oder Elektrolytkupfer aufweisen.

Gemäß einer nächsten Ausgestaltung weist der Träger wenigstens eine erste Aussparung auf und die biegbare Leiterplatte weist wenigstens einen ersten Verbindungsbereich auf, wobei vorzugsweise die Form der ersten Aussparung im Wesentlichen der Form des ersten Verbindungsbereiches entspricht und wobei die biegbare Leiterplatte mit dem ersten Verbindungsbereich in die erste Aussparung hineingelegt ist. Dadurch dass die biegbare Leiterplatte mit dem Verbindungsbereich vorzugsweise passgenau in die erste Aussparung hineingelegt ist, wird sie von dem Träger zumindest derart gehalten, dass während des Einsteckens in die Aufnahmeeinheit die biegbare Leiterplatte nicht verrutschen kann.

Besonders bevorzugt weist der Träger wenigstens eine erste und eine zweite Aussparungen auf, wobei die Leiterplatte wenigstens einen ersten und einen zweiten Verbindungsbereich aufweist, und wobei die Leiterplatte mit dem ersten Verbindungsbereich in der ersten Aussparung und mit dem zweiten Verbindungsbereich in der zweiten Aussparung angeordnet ist.

Gemäß einer nächsten Ausgestaltung weist der Träger eine Aussparung auf, die im Wesentlichen der Form der Kontaktfläche der biegbaren Leiterplatte mit dem Träger entspricht, sodass die biegbare Leiterplatte durchgängig zumindest durch die Kanten der Aussparung am Träger gehalten wird.

Gemäß einer nächsten Ausgestaltung weist der Träger wenigstens ein Fixierelement zur Fixierung der Leiterplatte an dem Träger auf.

Besonders bevorzugt ist das wenigstens eine Fixierelement ein Schlitz und/oder eine Nut und/oder ein Falz und/oder eine Fase und/oder eine die Leiterplatte, vorzugsweise schräg, überragende Kante.

Dabei schließt eine die Leiterplatte schräg überragende Kante einen spitzen Winkel vorzugsweise zwischen 45 und 90° mit der Aufnahmefläche des Trägers ein. Besonders bevorzugt weist der Träger wenigstens zwei die Leiterplatte schräg überragende Kanten auf, die einander gegenüberliegend angeordnet sind.

Gemäß einer nächsten Ausgestaltung weist die biegbare Leiterplatte, vorzugsweise im Verbindungsbereich, wenigstens ein Befestigungselement auf, wobei das wenigstens eine Befestigungselement vorzugsweise mit dem wenigstens einen Fixierelement in Wirkzusammenhang steht.

Beispielsweise ist das Befestigungselement als Vorsprung ausgebildet, der in dem Fixierelement angeordnet ist, sodass die Leiterplatte formschlüssig zumindest in eine Raumrichtung an dem Träger gehalten wird. Beispielsweise kann der Vorsprung derart ausgebildet und angeordnet sein, dass er zur Fixierung in das Fixierelement hineingebogen oder hineingeschoben wird.

Besonders bevorzugt ist die Fixierung der Leiterplatte durch die Kombination aus dem wenigstens einen Fixierungselement und dem wenigstens einen Befestigungselement derart ausgebildet, dass die Leiterplatte in drei Raumrichtungen fixiert ist.

Gemäß einer weiteren bevorzugten Ausgestaltung ist auf der biegbaren Leiterplatte ein Masseanschluss angeordnet, wobei der Masseanschluss mit dem Gehäuse des Durchflussmessgeräts verbunden ist. Besonders bevorzugt ist der Masseanschluss auf einem zweiten Verbindungsbereich der biegbaren Leiterplatte angeordnet, wobei der zweite Verbindungsbereich vorzugsweise im Wesentlichen passgenau in der zweiten Aussparung des Trägers angeordnet ist.

Gemäß einer nächsten bevorzugten Ausgestaltung weist die biegbare Leiterplatte mehrere funktionelle Teilbereiche auf, wobei die funktionellen Teilbereiche auf unterschiedlichen Armen der Leiterplatte angeordnet sind, sodass die funktionellen Teilbereiche durch separates Biegen der Arme an unterschiedlichen Anbindungsbereichen des Durchflussmessgeräts angeordnet sind.

Ein erster Teilbereich ist zur Anbindung an den Träger ausgebildet. Ein zweiter Teilbereich ist zur Anbindung an die Messanordnung ausgebildet. Ein dritter Teilbereich dient zur Anbindung an die Stromversorgung. Besonders bevorzugt ist in diesem Teilbereich ein Stecker mit der Leiterplatte verbunden.

Gemäß einer weiter bevorzugten Ausgestaltung ist auf dem Sensor ein Abdeckelement angeordnet. Das Abdeckelement ist vorzugsweise als Isolationselement zur Isolierung des Sensors ausgebildet. Alternativ oder zusätzlich weist das Abdeckelement eine hohe Wärmeleitfähigkeit auf, sodass in dem Fall, in dem der Sensor als Temperatursensor ausgebildet ist, eine schnelle Antwortzeit des Temperatursensors garantiert werden kann. Gemäß einer Ausgestaltung weist das Abdeckelement wenigstens zwei Schichten auf, wobei wenigstens eine Schicht leitfähig ausgebildet ist und wobei wenigstens eine Schicht nicht-leitfähig ausgebildet ist. Besonders bevorzugt ist die nicht-leitfähige, isolierende Schicht dünner, insbesondere viel dünner, als die leitfähige Schicht ausgebildet. Gemäß einer Ausgestaltung ist die nicht-leitfähige Schicht eine Polyimidschicht.

Gemäß einer weiter bevorzugten Ausgestaltung ist die Sensoreinheit formschlüssig und/oder kraftschlüssig in der Aufnahmeeinheit gehalten. Hierzu wird die Sensoreinheit vorzugsweise in die Aufnahmeeinheit gepresst.

Gemäß einer zweiten Lehre der vorliegenden Erfindung wird die eingangs dargelegte Aufgabe durch eine eingangs beschriebene Sensoreinheit zum Einbau in ein erfindungsgemäßes Durchflussmessgerät dadurch gelöst, dass der wenigstens eine Sensor auf der wenigstens einen biegbare Leiterplatte angeordnet ist, wobei die wenigstens eine biegbare Leiterplatte zumindest teilweise um den Träger gewickelt oder gefaltet ist.

Die erfindungsgemäße Sensoreinheit weist den Vorteil auf, dass der Einbau des Sensors einerseits besonders leicht erfolgen kann, da der die Sensoreinheit lediglich in die Aufnahmeeinheit eingesteckt werden muss und andererseits der Sensor dadurch auch leicht ausgetauscht werden kann.

Besonders bevorzugt ist die Sensoreinheit gemäß einer der zuvor beschriebenen Ausgestaltungen ausgebildet.

Gemäß einer dritten Lehre der vorliegenden Erfindung wird die eingangs genannte Aufgabe durch ein eingangs beschriebenes Verfahren zur Herstellung eines Durchflussmessgeräts dadurch gelöst,
dass zunächst die wenigstens eine biegbare Leiterplatte zumindest teilweise um den Träger gewickelt und/oder gefaltet wird und
dass anschließend die Sensoreinheit in die Aufnahmeeinheit gesteckt wird, sodass der Sensor innerhalb des Messrohrs angeordnet ist.

Das erfindungsgemäße Verfahren weist den Vorteil auf, dass zur Montage sowie zur korrekten Positionierung des zusätzlichen Sensors die Sensoreinheit lediglich eingesteckt wird.

Es gibt nun eine Vielzahl von Möglichkeiten das erfindungsgemäße Durchflussmessgerät, die erfindungsgemäße Sensoreinheit und das erfindungsgemäße Verfahren auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung.

### In der Zeichnung zeigen

- Fig. 1: ein Ausführungsbeispiel einer erfindungsgemäßen Sensoreinheit im nicht verbundenen Zustand,
- Fig. 2: ein Ausführungsbeispiel einer erfindungsgemäßen Sensoreinheit, wobei die biegbare Leiterplatte um den Träger gefaltet ist,
- Fig. 3: das in Fig. 2 dargestellte Ausführungsbeispiel in anderer Ansicht,
- Fig. 4: ein weiteres Ausführungsbeispiel einer erfindungsgemäßen Sensoreinheit,
- Fig. 5: ein weiteres Ausführungsbeispiel einer erfindungsgemäßen Sensoreinheit,
- Fig. 6: die Anbindung einer erfindungsgemäßen Sensoreinheit an ein Messrohr eines Durchflussmessgeräts,
- Fig. 7: ein Ausführungsbeispiel eines erfindungsgemäßen Durchflussmessgeräts
- Fig. 8: ein Ausführungsbeispiel einer biegbaren Leiterplatte,
- Fig. 9: ein weiteres Ausführungsbeispiel einer erfindungsgemäßen Sensoreinheit,
- Fig. 10: ein Ausführungsbeispiel eines Verfahrens zur Herstellung eines Durchflussmessgeräts.

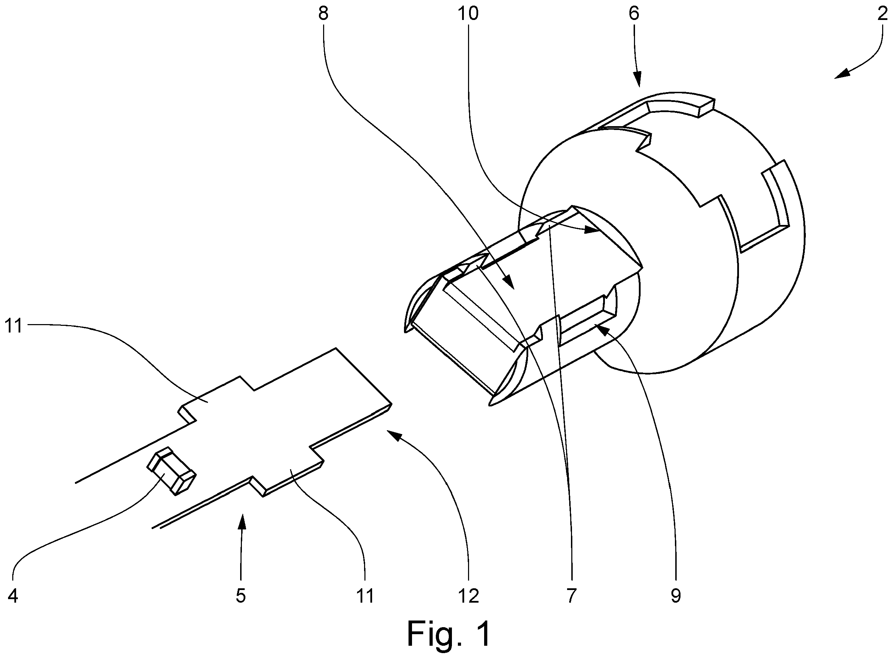

Fig. 1 zeigt ein erstes Ausführungsbeispiel einer Sensoreinheit 2. Die Sensoreinheit 2 umfasst einen Sensor 4, der auf einer biegbaren Leiterplatte 5 angeordnet ist, sowie einen Träger 6 zur Aufnahme der Leiterplatte 5. Im dargestellten Ausführungsbeispiel ist der Sensor 4 als Temperatursensor ausgebildet. Alternativ kann der Sensor 4 selbstverständlich auch als Drucksensor oder als Leitfähigkeitssensor ausgebildet sein.

Die Darstellung zeigt die Sensoreinheit 2 im nicht verbundenen Zustand, d.h die biegbare Leiterplatte 5 ist nicht unmittelbar auf dem Träger 6 angeordnet. Zur Anbindung an den Träger 6 weist die Leiterplatte einen ersten Verbindungsbereich 12 auf. Zur Aufnahme der Leiterplatte 5 weist der Träger 6 einen Aufnahmebereich 8 auf, in den der Verbindungsbereich 12 eingelegt werden kann.

Zur Fixierung der Leiterplatte 5 auf dem Träger 6 weist der Träger Fixierelemente in Form von Kanten 7 auf. Zur besseren Fixierung können die Kanten 7 mit der Aufnahmefläche des Trägers 6 auch einen spitzen Winkel zwischen 45 und 90° einschließen. Die Leiterplatte 5 kann somit zur Anbindung an den Träger 6 in den Aufnahmebereich 8 des Trägers 6 eingelegt und durch die die Leiterplatte überragenden Kanten 7 fixiert werden. Weiterhin weist der Träger 6 im Aufnahmebereich 8 einen Schlitz 10 zur Fixierung auf, in den die Leiterplatte 5 hineingeschoben werden kann.

Zudem weist der Träger 6 im Bereich der Aufnahmefläche zwei Falze 9 zur weiteren Fixierung auf. Zur Anbindung weist die Leiterplatte 5 Befestigungselemente in Form von seitlichen Vorsprüngen 11 auf, die im verbundenen Zustand in die Falze 9 gefaltet werden können.

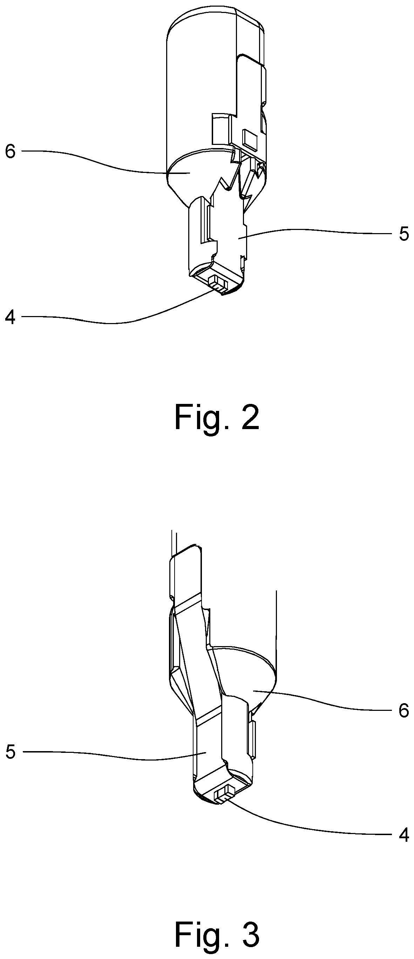

Fig. 2 zeigt ein Ausführungsbeispiel einer Sensoreinheit 2, wobei die biegbare Leiterplatte 5 um den Träger 6 gebogen ist, sodass die Leiterplatte 5 mit dem Träger 6 montiert werden kann. Der Sensor 4 ist in dieser Anordnung unterhalb des steckerartig ausgebildeten Trägers 6 angeordnet, sodass der Sensor 4 durch ein einfaches Einstecken in die Aufnahmeeinheit 16 eines Messrohrs 17 in dem Messrohr 17 platziert werden kann.

Fig. 3 zeigt das in Fig. 2 dargestellte Ausführungsbeispiel einer Sensoreinheit 2 in gedrehter Ansicht. Die Darstellung zeigt, dass neben der Fixierung der Leiterplatte 5 im ersten Verbindungsbereich 12 die Leiterplatte 5 durch Kanten auch auf der dem ersten Verbindungsbereich 12 gegenüberliegenden Seite an dem Träger 6 fixiert ist. Hierdurch kann sichergestellt werden, dass die Leiterplatte 5 flächig an dem Träger 6 anliegt.

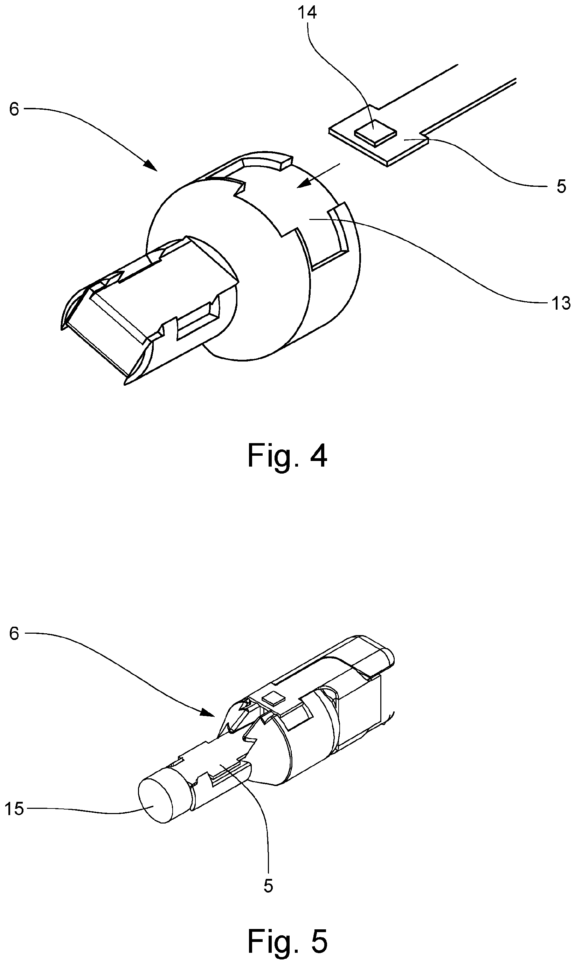

Fig. 4 zeigt ein weiteres Ausführungsbeispiel einer Sensoreinheit 2, wobei der Träger 6 einen weiteren Aufnahmebereich in Form einer Aussparung 13 zur Aufnahme eines weiteren funktionellen Teils der Leiterplatte 5 aufweist, wobei der entsprechende Verbindungsbereich der Leiterplatte 5 derart ausgebildet ist, dass er in die Aussparung 13 hineingelegt werden kann. Durch Anschläge wird der Verbindungsbereich in der Aussparung 13 des Trägers 6 gehalten. Auf dem Verbindungsbereich der Leiterplatte ist ein Masseanschluss 14 angeordnet, der im eingesteckten Zustand des Trägers zur Anbindung an das Gehäuse ausgebildet ist.

Fig. 5 zeigt ein Ausführungsbeispiel einer Sensoreinheit 2, in der die Leiterplatte 5 vollständig um die Längsachse des Trägers 6 gefaltet ist. Auf dem Sensor 4 ist ein Abdeckelement 15 angeordnet. Dieses Abdeckelement 15 dient im Betrieb zur Isolation des Sensors 4. Darüber hinaus weist das Abdeckelement 15 eine hohe Wärmeleitfähigkeit auf, sodass im Betrieb die Antwortzeit des Sensors 4, der im dargestellten Ausführungsbeispiel als Temperatursensor ausgebildet ist, besonders hoch ist.

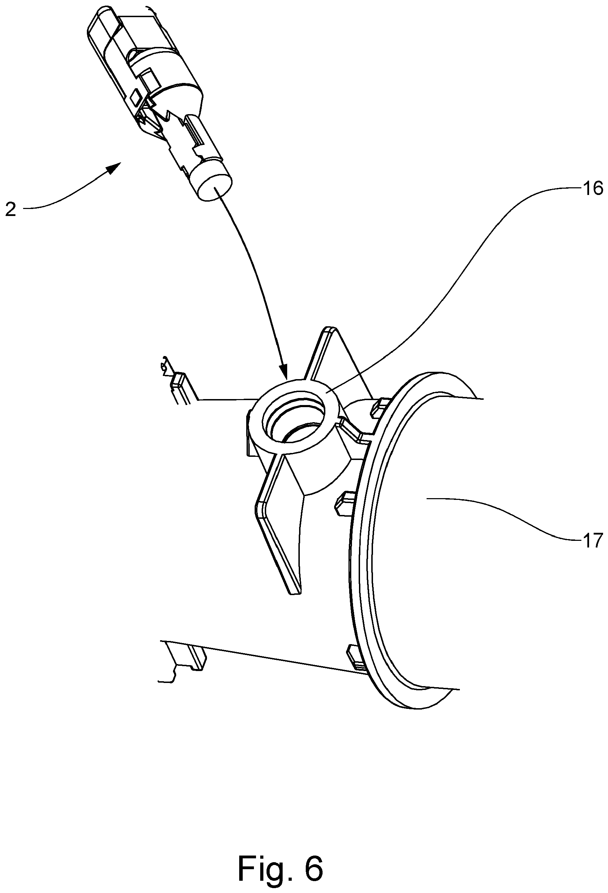

Fig. 6 zeigt eine Kombination aus der in Fig. 5 dargestellten Sensoreinheit 2 und einer becherförmigen Aufnahmeeinheit 16 zur Aufnahme der Sensoreinheit 2. Die Aufnahmeeinheit 16 ist an einem Messrohr 17 eines Durchflussmessgeräts 1 angeordnet. Die Darstellung zeigt, dass die Sensoreinheit 2 insgesamt derart ausgestaltet ist, dass sie zur Verbindung mit dem Durchflussmessgerät 1 und insofern zur Platzierung des Sensors 4 lediglich in die Aufnahmeeinheit 16 eingesteckt werden muss. In der Aufnahmeeinheit 16 wird die Sensoreinheit 2 dann kraftschlüssig gehalten, sodass gleichzeitig ein Austauschen der Sensoreinheit besonders leicht erfolgen kann.

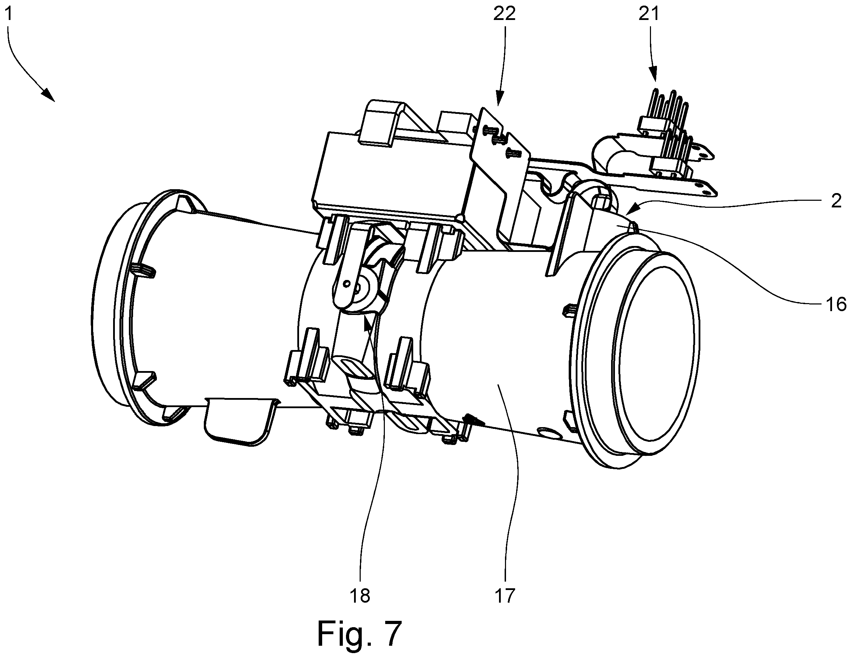

Fig. 7 zeigt ein Ausführungsbeispiel eines Durchflussmessgeräts 1 in Form eines Magnetisch-induktiven Durchflussmessgerätes, umfassend ein Messrohr 17, eine Messanordnung 18 zur Messung des Durchflusses eines durch das Messrohr 17 strömenden Mediums, mit wenigstens einer Aufnahmeeinheit 16 für eine Sensoreinheit 2 und mit einer in der Aufnahmeeinheit 16 angeordneten Sensoreinheit 2. Die Leiterplatte 5 der Sensoreinheit 2 weist neben der Anbindung an den Träger 6 weitere funktionelle Bereiche auf. Im Detail ist die Leiterplatte 5 mit einem funktionellen Bereich 22 auch an die Messanordnung 18 zur Messung des Durchflusses angebunden und weist darüber hinaus Stecker 21 zur Versorgung und/oder Kommunikation der Messanordnung und/oder des Sensors auf.

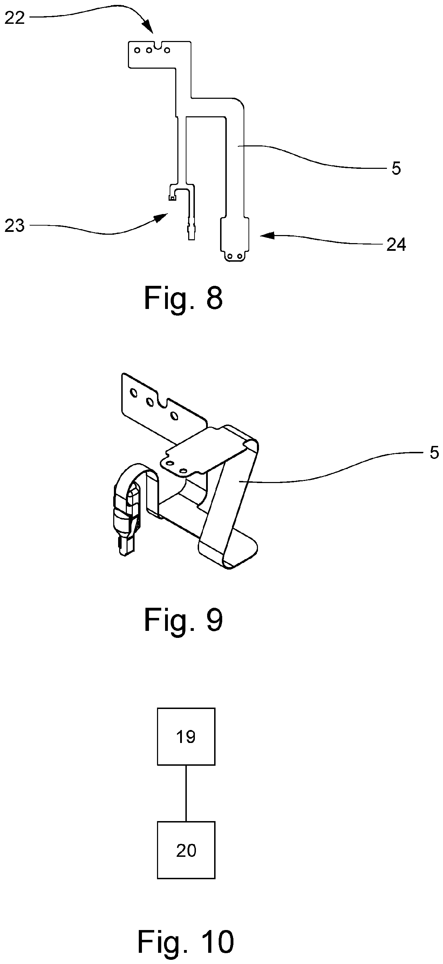

Die Fig. 8 zeigt ein Ausführungsbeispiel einer erfindungsgemäßen Leiterplatte 5, wobei die Leiterplatte 5 mehrere funktionelle Teilbereiche aufweist. Ein erster Teilbereich 23 dient der Anbindung an den Träger 6. Ein zweiter Teilbereich 22 dient der Anbindung an die Messanordnung 18 zur Messung des Durchflusses durch das Messrohr und ein dritter Teilbereich 24 dient zur Versorgung und/oder Kommunikation der Messanordnung 18 und/oder des Sensors 4. Durch vorteilhaftes Biegen der Leiterplatte 5 können sämtliche funktionellen Teilbereiche an der zur Verbindung vorgesehenen Stelle angeordnet werden.

Fig. 9 zeigt hierzu ein Ausführungsbeispiel der Sensoreinheit 2 im gebogenen Zustand, wobei die Leiterplatte 5 zumindest teilweise um den Träger 6 gewickelt ist.

Fig. 10 zeigt ein erstes Ausführungsbeispiel eines erfindungsgemäßen Verfahrens 3 zur Herstellung, im Detail zur Montage eines Durchflussmessgeräts 1, wobei das Durchflussmessgerät 1 gemäß dem in Fig. 7 gezeigten Ausführungsbeispiel ausgebildet ist.

In einem ersten Schritt 19 wird die biegbare Leiterplatte 5 zumindest teilweise um den Träger 6 gefaltet und an diesem fixiert.

Anschließend wird die Sensoreinheit 2 in die Aufnahmeeinheit 16 gesteckt 20, sodass der Sensor 4 innerhalb des Messrohrs 17 angeordnet ist. Gleichzeitig sind die übrigen funktionellen Bereiche 22 und 24 für die vorgesehene Anwendung passend platziert.

Die Montage des Sensors 4 ist insofern besonders leicht. Zudem lässt sich die Sensoreinheit auch besonders leicht austauschen.

### Bezugszeichen

- 1: Durchflussmessgerät
- 2: Sensoreinheit
- 3: Verfahren zur Herstellung eines Durchflussmessgeräts
- 4: Sensor
- 5: biegbare Leiterplatte
- 6: Träger
- 7: Kante
- 8: Aufnahmefläche
- 9: Falz
- 10: Schlitz
- 11: Vorsprung
- 12: Verbindungsbereich
- 13: Aussparung
- 14: Masseanschluss
- 15: Deckelement
- 16: Aufnahmeeinheit
- 17: Messrohr
- 18: Messanordnung zur Messung des Durchflusses
- 19: Faltung der Leiterplatte um den Träger
- 20: Einstecken der Sensoreinheit in die Aufnahmeeinheit
- 21: Stecker
- 22: funktioneller Bereich zur Anbindung an die Messanordnung
- 23: funktioneller Bereich zur Anbindung an den Träger
- 24: funktioneller Bereich zur Anbindung an die Versorgung

## Patentansprüche

1. Durchflussmessgerät (1) mit wenigstens einem Messrohr (17), mit einer Messanordnung (18) zur Messung des Durchflusses eines durch das Messrohr (17) strömenden Mediums, mit wenigstens einer Aufnahmeeinheit (16) für eine Sensoreinheit (2) und mit einer Sensoreinheit (2),
wobei die Aufnahmeeinheit (16) an dem Messrohr (17) angeordnet ist,
wobei die Sensoreinheit (2) wenigstens einen Sensor (4) und wenigstens eine biegbare Leiterplatte (5) umfasst,
wobei der wenigstens eine Sensor (4) auf der wenigstens einen biegbaren Leiterplatte (5) angeordnet ist und
wobei die Sensoreinheit (2) in die Aufnahmeeinheit (16) eingesteckt ist,
**dadurch gekennzeichnet, dass** die Sensoreinheit (2) wenigstens einen Träger (6) umfasst und, dass
die wenigstens eine biegbare Leiterplatte (5) zumindest teilweise derart um den Träger (6) gewickelt oder gefaltet ist, dass der Sensor (4) im eingesteckten Zustand innerhalb des Messrohrs (17) angeordnet ist.

2. Durchflussmessgerät (1) nach Anspruch 1, **dadurch gekennzeichnet, dass** die Aufnahmeeinheit (16) becherförmig ausgebildet ist und dass der Träger (6) der Sensoreinheit (2) zumindest teilweise stopfenförmig ausgebildet ist, sodass der Träger (6) als Stopfen die becherförmige Aufnahmeeinheit (16) verschließt.

3. Durchflussmessgerät (1) nach Anspruch 1 oder 2, **dadurch gekennzeichnet, dass** der wenigstens eine Sensor (4) ein Temperatursensor und/oder ein Drucksensor und/oder ein Leitfähigkeitssensor ist.

4. Durchflussmessgerät (1) nach einem der Ansprüche 1 bis 3, **dadurch gekennzeichnet, dass** die biegbare Leiterplatte (5) eine flexible Leiterplatte, insbesondere eine Flexfolie, oder eine starrflexe Leiterplatte oder eine semiflexe Leiterplatte ist.

5. Durchflussmessgerät (1) nach einem der Ansprüche 1 bis 4, **dadurch gekennzeichnet, dass** die biegbare Leiterplatte (5) den Träger (6) zumindest teilweise in Längsrichtung und/oder zumindest teilweise in quer zur Längsrichtung umschließt.

6. Durchflussmessgerät (1) nach einem der Ansprüche 1 bis 5, **dadurch gekennzeichnet, dass** der Träger (6) wenigstens eine Aussparung (13) aufweist und dass die biegbare Leiterplatte (5) wenigstens einen ersten Verbindungsbereich (12) aufweist, wobei vorzugsweise die Form der Aussparung (13) im Wesentlichen der Form des ersten Verbindungsbereiches (12) entspricht und wobei die biegbare Leiterplatte (5) mit dem Verbindungsbereich (12) in die wenigstens eine Aussparung (13) hineingelegt ist.

7. Durchflussmessgerät (1) nach einem der Ansprüche 1 bis 6, **dadurch gekennzeichnet, dass** der Träger (6) wenigstens ein Fixierelement zur Fixierung der Leiterplatte (5) an dem Träger (6) aufweist.

8. Durchflussmessgerät (1) nach Anspruch 7, **dadurch gekennzeichnet, dass** das wenigstens eine Fixierelement ein Schlitz (10) und/oder eine Nut und/oder ein Falz (9) und/oder eine Fase und/oder eine die Leiterplatte, vorzugsweise schräg, überragende Kante (7) ist.

9. Durchflussmessgerät (1) nach einem der Ansprüche 1 bis 8, **dadurch gekennzeichnet, dass** die biegbare Leiterplatte (5), vorzugsweise im Verbindungsbereich, wenigstens ein Befestigungselement aufweist, wobei das wenigstens eine Befestigungselement vorzugsweise mit dem wenigstens einen Fixierelement in Wirkzusammenhang steht.

10. Durchflussmessgerät (1) nach einem der Ansprüche 1 bis 9, **dadurch gekennzeichnet, dass** auf der biegbaren Leiterplatte (5) ein Masseanschluss (14) angeordnet ist und dass der Masseanschluss (14) mit dem Gehäuse des Durchflussmessgeräts (1) verbunden ist.

11. Durchflussmessgerät (1) nach einem der Ansprüche 1 bis 10, **dadurch gekennzeichnet, dass** die biegbare Leiterplatte (5) mehrere funktionelle Teilbereiche aufweist, wobei die funktionellen Teilbereiche auf unterschiedlichen Armen der Leiterplatte angeordnet sind, sodass die funktionellen Teilbereiche durch separates Biegen der Arme an unterschiedlichen Anbindungsbereichen des Durchflussmessgeräts angeordnet sind.

12. Durchflussmessgerät (1) nach einem der Ansprüche 1 bis 11, **dadurch gekennzeichnet, dass** auf dem Sensor (4) ein Abdeckelement (15), vorgzusweise ein Isolationselement und/oder ein Wärmeleitungselement, angeordnet ist.

13. Durchflussmessgerät (1) nach einem der Ansprüche 1 bis 12, **dadurch gekennzeichnet, dass** die Sensoreinheit (2) form- und/oder kraftschlüssig in der Aufnahmeeinheit (16) gehalten ist.

14. Sensoreinheit (2) zum Einbau in ein Durchflussmessgerät (1) gemäß einem der Ansprüche 1 bis 13 mit wenigstens einem Sensor (4), und mit wenigstens einer biegbaren Leiterplatte (5),
**dadurch gekennzeichnet,**
**dass** die Sensoreinheit (2) wenigstens einen Träger (6) umfasst und, dass der wenigstens eine Sensor (4) auf der wenigstens einen biegbare Leiterplatte (5) angeordnet ist,
wobei die wenigstens eine biegbare Leiterplatte (5) zumindest teilweise um den Träger (6) gewickelt oder gefaltet ist.

15. Sensoreinheit (2) gemäß Anspruch 14, **dadurch gekennzeichnet, dass** die Sensoreinheit (2) die Merkmale gemäß einem der Ansprüche 2 bis 13 aufweist.

16. Verfahren (3) zur Herstellung eines Durchflussmessgeräts (1), wobei das Durchflussmessgerät (1) gemäß einem der Ansprüche 1 bis 11 ausgebildet ist,
**dadurch gekennzeichnet,**
**dass** zunächst die wenigstens eine biegbare Leiterplatte (5) zumindest teilweise um den Träger (6) gewickelt und/oder gefaltet wird und
**dass** anschließend die Sensoreinheit (2) in die Aufnahmeeinheit (16) gesteckt wird, sodass der Sensor (4) innerhalb des Messrohrs (17) angeordnet ist.

## Claims

1. Flowmeter (1) with at least one measuring tube (17), with a measuring arrangement (18) for measuring the flow of a medium flowing through the measuring tube (17), with at least one receiving unit (16) for a sensor unit (2) and with a sensor unit (2),
wherein the receiving unit (16) is arranged on the measuring tube (17),
wherein the sensor unit (2) comprises at least one sensor (4) and at least one flexible printed circuit board (5),
wherein the at least one sensor (4) is arranged on the at least one flexible printed circuit board (5), and
wherein the sensor unit (2) is plugged into the receiving unit (16),
**characterized in**
**that** the sensor unit (2) comprises at least one carrier (6) and that the at least one flexible printed circuit board (5) is at least partially wrapped or folded around the carrier (6) such that the sensor (4) is arranged inside the measuring tube (17) in the inserted state.

2. Flowmeter (1) according to claim 1, **characterized in that** the receiving unit (16) is cup-shaped and that the carrier (6) of the sensor unit (2) is at least partially plug-shaped so that the carrier (6) closes the cup-shaped receiving unit (16) as a plug.

3. Flowmeter (1) according to claim 1 or 2, **characterized in that** the at least one sensor (4) is a temperature sensor and/or a pressure sensor and/or a conductivity sensor.

4. Flowmeter (1) according to any one of claims 1 to 3, **characterized in that** the flexible printed circuit board (5) is a bendable printed circuit board, in particular a flex foil, or a rigid-flex printed circuit board or a semi-flexible printed circuit board.

5. Flowmeter (1) according to any one of claims 1 to 4, **characterized in that** the flexible printed circuit board (5) encloses the carrier (6) at least partially in the longitudinal direction and/or at least partially transverse to the longitudinal direction.

6. Flowmeter (1) according to any one of claims 1 to 5, **characterized in that** the carrier (6) has at least one recess (13) and that the flexible printed circuit board (5) has at least one first connection area (12), wherein preferably the shape of the recess (13) substantially corresponds to the shape of the first connection area (12), and wherein the flexible printed circuit board (5) is placed with the connection area (12) into the at least one recess (13).

7. Flowmeter (1) according to any one of claims 1 to 6, **characterized in that** the carrier (6) has at least one fixing element for fixing the printed circuit board (5) to the carrier (6).

8. Flowmeter (1) according to claim 7, **characterized in that** the at least one fixing element is a slot (10) and/or a groove and/or a seam (9) and/or a chamfer and/or an edge (7) projecting, preferably obliquely, beyond the printed circuit board.

9. Flowmeter (1) according to any one of claims 1 to 8, **characterized in that** the flexible printed circuit board (5), preferably in the connection area, has at least one mounting element, wherein the at least one mounting element is preferably in operative connection with the at least one fixing element.

10. Flowmeter (1) according to any one of claims 1 to 9, **characterized in that** a ground connection (14) is arranged on the flexible printed circuit board (5) and that the ground connection (14) is connected to the housing of the flowmeter (1).

11. Flowmeter (1) according to any one of claims 1 to 10, **characterized in that** the flexible printed circuit board (5) has several functional subsections, wherein the functional subsections are arranged on different arms of the flexible printed circuit board, such that the functional subsections are positioned at the point of their connection by separately bending of the arms.

12. Flowmeter (1) according to any one of claims 1 to 11, **characterized in that** a cover element (15), preferably an insulation element and/or a heat conduction element, is arranged on the sensor (4).

13. Flowmeter (1) according to any one of claims 1 to 12, **characterized in that** the sensor unit (2) is held positively and/or non-positively in the receiving unit (16).

14. Sensor unit (2) for installation in a flowmeter (1) according to any one of claims 1 to 13 with at least one sensor (4) and with at least one flexible printed circuit board (5),
**characterized in**
**that** the sensor unit (2) comprises at least one carrier (6) and that the at least one sensor (4) is arranged on the at least one flexible printed circuit board (5),
wherein the at least one flexible printed circuit board (5) is at least partially wrapped or folded around the carrier (6).

15. Sensor unit (2) according to claim 14, **characterized in that** the sensor unit (2) has features according to any one of claims 2 to 13.

16. Method for manufacturing a flowmeter (1), wherein the flowmeter (1) is designed according to any one of claims 1 to 11,
**characterized in**
**that** the at least one flexible printed circuit board (5) is first wrapped and/or folded at least partially around the carrier (6), and
**that** the sensor unit (2) is then plugged into the receiving unit (16) so that the sensor (4) is arranged inside the measuring tube (17).

## Revendications

1. Débitmètre (1), comprenant au moins un tube de mesure (17), comprenant un arrangement de mesure (18) destiné à mesurer le débit d'un fluide qui s'écoule à travers le tube de mesure (17), comprenant au moins une unité de logement (16) pour une unité de capteur (2) et comprenant une unité de capteur (2),
l'unité de logement (16) étant disposée sur le tube de mesure (17),
l'unité de capture (2) comportant au moins un capteur (4) et au moins un circuit imprimé pliable (5),
l'au moins un capteur (4) étant disposé sur l'au moins un circuit imprimé pliable (5) et
l'unité de capteur (2) étant insérée dans l'unité de logement (16),
**caractérisé en ce que** l'unité de capteur (2) comporte au moins un élément porteur (6) et **en ce que** l'au moins un circuit imprimé pliable (5) est enroulé ou plié au moins partiellement autour de l'élément porteur (6) de telle sorte que le capteur (4), dans un état inséré, est disposé à l'intérieur du tube de mesure (17).

2. Débitmètre (1) selon la revendication 1, **caractérisé en ce que** l'unité de logement (16) est réalisée en forme de coupe et **en ce que** l'élément porteur (6) de l'unité de capteur (2) est réalisé au moins partiellement en forme de bouchon, de sorte que l'élément porteur (6) en tant que bouchon ferme l'unité de logement (16) en forme de coupe.

3. Débitmètre (1) selon la revendication 1 ou 2, **caractérisé en ce que** l'au moins un capteur (4) est un capteur de température et/ou un capteur de pression et/ou un capteur de conductivité.

4. Débitmètre (1) selon l'une des revendications 1 à 3, **caractérisé en ce que** le circuit imprimé pliable (5) est un circuit imprimé souple, notamment un film flexible, ou un circuit imprimé rigide en flexion ou un circuit imprimé semi-flexible.

5. Débitmètre (1) selon l'une des revendications 1 à 4, **caractérisé en ce que** le circuit imprimé pliable (5) entoure l'élément porteur (6) au moins partiellement dans la direction longitudinale et/ou au moins partiellement transversalement à la direction longitudinale.

6. Débitmètre (1) selon l'une des revendications 1 à 5, **caractérisé en ce que** l'élément porteur (6) possède au moins un creux (13) et **en ce que** le circuit imprimé pliable (5) possède au moins une première zone de liaison (12), la forme du creux (13) correspondant de préférence sensiblement à la forme de la première zone de liaison (12) et le circuit imprimé pliable (5) étant introduit dans l'au moins un creux (13) avec la zone de liaison (12).

7. Débitmètre (1) selon l'une des revendications 1 à 6, **caractérisé en ce que** l'élément porteur (6) possède au moins un élément de blocage destiné à bloquer le circuit imprimé pliable (5) sur l'élément porteur (6).

8. Débitmètre (1) selon la revendication 7, **caractérisé en ce que** l'au moins un élément de blocage est une fente (10) et/ou une rainure et/ou un pli (9) et/ou un chanfrein et/ou une arête (7) qui fait saillie, de préférence en biais, du circuit imprimé.

9. Débitmètre (1) selon l'une des revendications 1 à 8, **caractérisé en ce que** le circuit imprimé pliable (5) possède, de préférence dans la zone de liaison, au moins un élément de fixation, l'au moins un élément de fixation se trouvant de préférence en relation de coopération avec l'au moins un élément de blocage.

10. Débitmètre (1) selon l'une des revendications 1 à 9, **caractérisé en ce qu'**une borne de masse (14) est disposée sur le circuit imprimé pliable (5) et **en ce que** la borne de masse (14) est reliée au boîtier du débitmètre (1).

11. Débitmètre (1) selon l'une des revendications 1 à 10, **caractérisé en ce que** le circuit imprimé pliable (5) possède plusieurs zones partielles fonctionnelles, les zones partielles fonctionnelles étant disposées sur différents bras du circuit imprimé, de sorte que les zones partielles fonctionnelles sont disposées au niveau de zones de connexion différentes du débitmètre par pliage séparé des bras.

12. Débitmètre (1) selon l'une des revendications 1 à 11, **caractérisé en ce qu'**un élément de recouvrement (15), de préférence un élément d'isolation et/ou un élément de conduction thermique est disposé sur le capteur (4).

13. Débitmètre (1) selon l'une des revendications 1 à 12, **caractérisé en ce que** l'unité de capteur (2) est maintenue dans l'unité de logement (16) par complémentarité de formes et/ou par adhérence.

14. Unité de capteur (2) destinée à être installée dans un débitmètre (1) selon l'une des revendications 1 à 13, comprenant au moins un capteur (4) et comprenant au moins un circuit imprimé pliable (5),
**caractérisée**
**en ce que** l'unité de capteur (2) comporte au moins un élément porteur (6) et en ce que l'au moins un capteur (4) est disposé sur l'au moins un circuit imprimé pliable (5),
l'au moins un circuit imprimé pliable (5) étant enroulé ou plié au moins partiellement autour de l'élément porteur (6).

15. Unité de capteur (2) selon la revendication 14, **caractérisée en ce que** l'unité de capteur (2) possède les caractéristiques selon l'une des revendications 2 à 13.

16. Procédé (3) de fabrication d'un débitmètre (1), le débitmètre (1) étant configuré selon l'une des revendications 1 à 11,
**caractérisé**
**en ce que** tout d'abord, l'au moins un circuit imprimé pliable (5) est enroulé et/ou plié au moins partiellement autour de l'élément porteur (6) et
qu'ensuite, l'unité de capteur (2) est insérée dans l'unité de logement (16) de sorte que le capteur (4) soit disposé à l'intérieur du tube de mesure (17).
